# DEMANDE DE BREVET EUROPEEN

(11) **EP 4 567 868 A1**
(43) Date de publication de la demande: **11.06.2025**
(21) Numéro de dépôt: 24215814.5
(22) Date de dépôt: 27.11.2024
(51) Int. Cl.: H01L 21/56, H01L 21/78, H01L 23/31, H01L 23/00

(54) **PROCEDE DE FABRICATION DE PUCES ELECTRONIQUES**

(30) Priorité: 07.12.2023 FR 2313734
(71) Demandeur: STMicroelectronics International N.V., 1228 Plan-les-Ouates, Geneva (CH)
(72) Inventeur: DELACOURT, Grégoire, 37000 TOURS (FR); FALLOURD, Ludovic, 37320 LOUANS (FR)
(74) Mandataire: Cabinet Beaumont

(57) **Abrégé**

La présente description concerne un procédé de fabrication d'une puce électronique à flancs passivés à partir d'un substrat (110) semiconducteur dont une première face est recouverte par des plages de connexion (107) et dans lequel sont formées des puces, le procédé comprenant les étapes suivantes :
- former des tranchées ou cavités entre les puces,
- déposer un matériau isolant (121) dans les tranchées ou cavités,
- séparer les puces en découpant au moins le matériau isolant (121) .

## Description

### Domaine technique

La présente description concerne le domaine des puces de type CSP (`Chip-Scale Package'). Elle concerne plus particulièrement un procédé de fabrication de puces nues (« bare dice » ou « bare chip »).

### Technique antérieure

Les puces nues comprennent un substrat, en matériau semiconducteur-conducteur, dans lequel des circuits électroniques ont été fabriqués. Le substrat est recouvert par des plages de connexion afin de permettre un assemblage de la puce, par exemple, avec une carte de circuit imprimé. Lors de l'assemblage de la puce, les plages de connexion sont soudées ou brasées à des pistes ou éléments métalliques du circuit imprimé. Cependant, lors de l'assemblage, il arrive que la brasure remonte le long des flancs de la puce. Or, comme les flancs de la puce sont en matériau semiconducteur, cela peut entraîner une perte des performances électriques (court-circuit, courant de fuite...). Il existe donc un besoin d'éviter de tels phénomènes.

De telles puces sont particulièrement intéressantes dans de nombreux domaines industriels, par exemple, dans le domaine automobile.

### Résumé de l'invention

Il existe un besoin d'améliorer au moins en partie certains aspects des procédés connus de fabrication des puces électroniques. Ce but est atteint par un procédé de fabrication d'une puce électronique à flancs passivés à partir d'un substrat semiconducteur dont une première face est recouverte par des plages de connexion et dans lequel sont formées des puces, le procédé comprenant les étapes suivantes :
- former des tranchées ou des cavités entre les puces,
- déposer un matériau isolant dans les tranchées ou dans les cavités,
- séparer les puces en découpant au moins le matériau isolant.

Selon un mode de réalisation particulier, des tranchées sont formées, les tranchées allant de la première face du substrat à une deuxième face du substrat.

Selon un mode de réalisation particulier, des cavités sont formées en découpant partiellement le substrat depuis la première face, la profondeur des cavités étant de préférence comprise entre 10 et 75 % de l'épaisseur du substrat.

Selon un mode de réalisation particulier, la largeur des tranchées ou des cavités est comprise entre 20 et 80 µm.

Selon un mode de réalisation particulier, avant l'étape de séparation des puces, le procédé comprend une étape au cours de laquelle le substrat est aminci à partir d'une deuxième face jusqu'à atteindre les cavités.

Selon un mode de réalisation particulier, le matériau isolant comprend un polymère ou une résine, de préférence une résine époxy ou phénolique, et des charges électriquement isolantes, par exemple des particules d'alumine ou de silice.

Selon un mode de réalisation particulier, le matériau isolant est déposé par impression par jet d'encre.

Selon un mode de réalisation particulier, le matériau isolant est déposé uniquement dans les tranchées ou dans les cavités. Autrement dit, il ne recouvre par la première face du substrat ni les plages de connexion.

Ce but est également atteint par une puce électronique à flancs passivés comprenant un substrat semiconducteur, ayant une première face recouverte par des plages de connexion, une deuxième face et des flancs, au moins une partie des flancs étant formée d'une couche de matériau isolant s'étendant depuis la première face du substrat.

Selon un mode de réalisation particulier, la couche de matériau isolant va de la première face à la deuxième face.

Selon un mode de réalisation particulier, une entaille partant de la première face du substrat est formée dans les flancs, l'entaille étant remplie par la couche de matériau isolant.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C et la figure 1D représentent des vues en coupe illustrant des étapes d'un procédé de fabrication d'une puce électronique à flancs passivés selon un mode de réalisation particulier;
la figure 2A, la figure 2B, la figure 2C et la figure 2D représentent des vues en coupe illustrant des étapes d'un procédé de fabrication d'une puce électronique à flancs passivés selon un autre mode de réalisation particulier ;
la figure 3A, la figure 3B, la figure 3C, la figure 3D et la figure 3E représentent des vues en coupe illustrant des étapes d'un procédé de fabrication d'une puce électronique à flancs passivés selon un autre mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

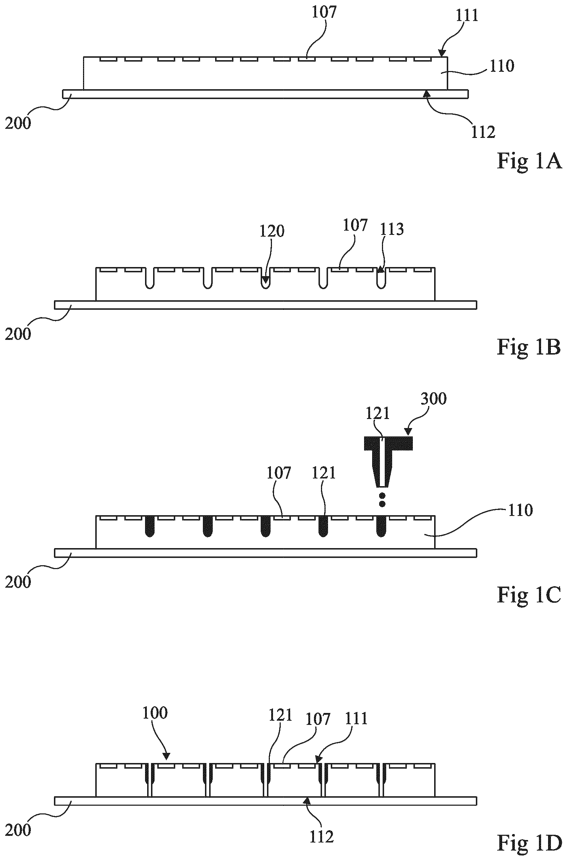

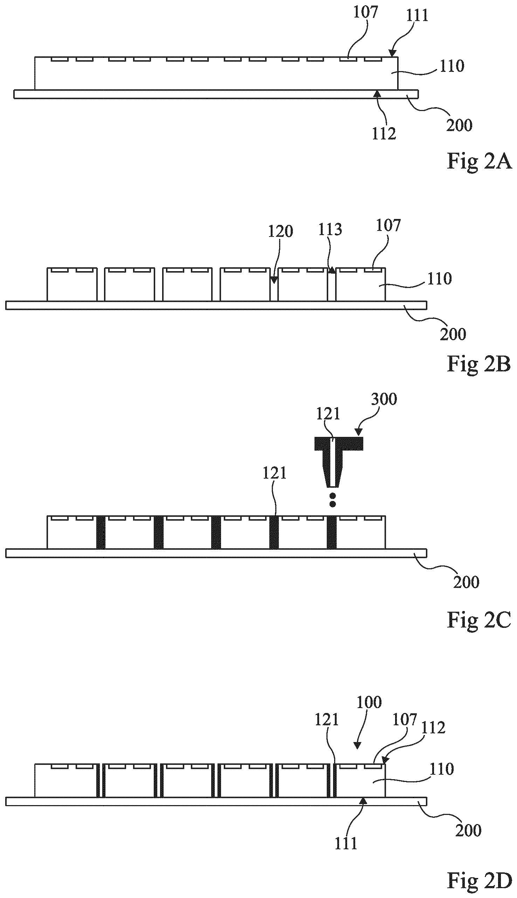

Nous allons maintenant décrire plus en détail le procédé de fabrication d'une puce électronique (« bare dice » ou « bare chip ») à flancs passivés en faisant référence aux figures 1A à 1D, 2A à 2D ainsi que 3A à 3E.

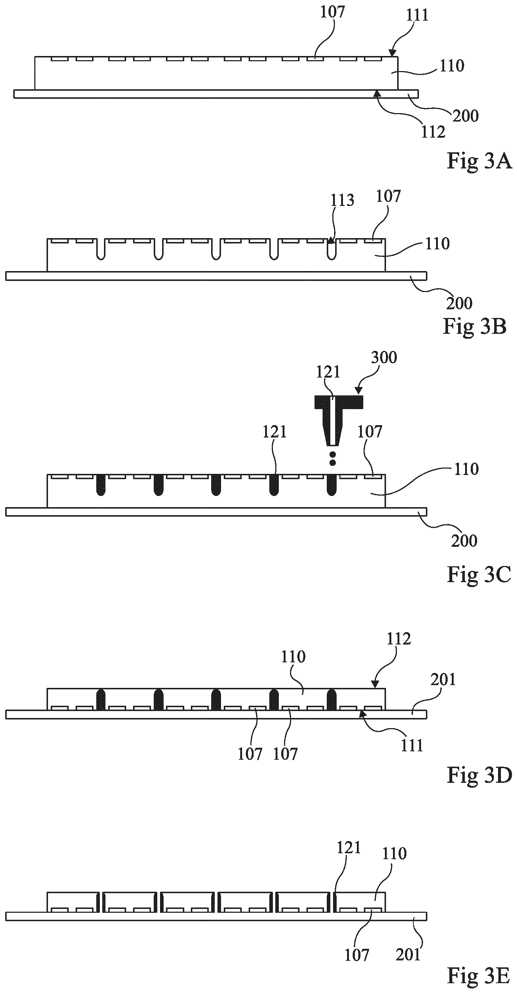

Le procédé comprend les étapes suivantes :
a) fournir un substrat 110 semiconducteur dont une première face 111 est recouverte par des plages de connexion 107 et dans lequel sont formées des puces 100 (figures 1A, 2A, 3A),
b) former des tranchées ou des cavités 120 dans le substrat 110 entre les puces 100 (figures 1B, 2B, 3B),
c) déposer un matériau isolant 121 dans les tranchées ou dans les cavités 120 (figures 1C, 2C, 3C),
   - éventuellement, réaliser une étape d'amincissement du substrat 110 en face arrière (figure 3D),
d) séparer les puces 100 en découpant à travers la couche de matériau isolant 121 (figures 1D, 2D, 3E).

Avec un tel procédé, les flancs 113 des puces 100 obtenues sont passivés au moyen d'une couche isolante 121. Une contamination potentielle (due à un assemblage déficient avec la carte) est ainsi évitée et il n'y a pas de dégradation des performances électriques.

A l'étape a), la fabrication du ou des composants discrets et/ou circuits intégrés est achevée. Les puces 100 sont formées dans un même substrat 110, et n'ont pas encore été individualisées.

Le substrat 110 comprend une première face 111 (face supérieure ou face avant ou encore face active) et une deuxième face 112 (face inférieure ou face arrière). Les deux faces 111 et 112 sont parallèles entre elles. Elles sont reliées entre elles par des parois latérales.

Le substrat 110 est, par exemple, un substrat semiconducteur, par exemple en silicium. Il peut également être en SiC.

Le substrat 110 a, par exemple, une épaisseur comprise entre 100 et 900 µm, de préférence entre 300 et 900 µm, par exemple une épaisseur d'environ 725 µm.

Une ou plusieurs plages de connexion 107 (aussi appelés contacts électriques) sont formées sur la face supérieure 111 du substrat 110 la puce électronique 100 et permettent de la connecter à d'autres éléments (puces ou circuits imprimés par exemple) . De préférence, il y a au moins deux plages de connexion.

Les plages de connexion électrique 107 sont, par exemple, à une distance de 10 à 30 µm de la paroi latérale de la puce. Les plages de connexion électrique 107 peuvent être positionnées sur la face supérieure 111 de la puce 100 ou affleurer la face supérieure 111 (i.e. arriver au niveau de la face supérieure 111 de la puce 100).

Les plages de connexion électriques 107 sont aussi appelés « UBM » (pour l'expression anglo-saxonne « Under Bump Metallization »). Les plages de connexion électrique 107 sont en un matériau conducteur. Les plages de connexion électrique 107 comprennent, avantageusement, au moins un des éléments suivants : or, titane, nickel, cuivre ou tungstène. De préférence, elles comprennent de l'or.

Des plots de connexion peuvent être formées sur les plages de connexion 107.

La puce 100 peut comprendre un composant discret ou plusieurs composants discrets. Le ou les composants discrets sont, par exemple, choisis parmi les transistors, diodes, thyristors, triacs, etc. La puce 100 peut comprendre un ou plusieurs circuits électroniques. La puce 100 permet de mettre en oeuvre différentes fonctions électroniques.

Le substrat fourni à l'étape a) est positionné sur un support 200. Le support 200 est adhésif.

Lors de l'étape b), le substrat 110 est découpé au moins partiellement entre les puces 100 pour former soit des cavités soit des tranchées. Les cavités ou les tranchées 120 définissent les contours latéraux des puces 100. Plus particulièrement, les cavités ou tranchées 120 s'étendent depuis la face supérieure 111 du substrat 110.

Selon une première variante de réalisation, par exemple représentée sur les figures 1B et 3B, des cavités 120 sont formées. Elles ont une profondeur inférieure à l'épaisseur du substrat 110.

La profondeur des cavités 120 est, par exemple, comprise entre 10 et 300 µm, de préférence entre 20 et 250 µm.

La profondeur des cavités 120 est de préférence comprise entre 10 et 75 % de l'épaisseur du substrat 110 de la puce finale. La profondeur des tranchées est ajustable selon les besoins de l'application.

La largeur des cavités 120 est, par exemple, comprise entre 20 et 80 µm.

Le fond des cavités peut être plat ou concave.

Selon une deuxième variante de réalisation, par exemple représentée sur la figure 2B, les tranchées traversent de part en part le substrat 110, c'est-à-dire que le substrat 110 est découpé depuis la première face 111 jusqu'à la deuxième face 112.

La largeur des tranchées 120 est, par exemple, comprise entre 20 et 80 µm.

Cette étape b) est réalisée au moyen d'un dispositif de découpe ou de gravure. Le dispositif de découpe est, par exemple, un outil de découpe/gravure mécanique comme une scie, ou un outil de gravure par un laser. Selon un mode de réalisation préféré, le dispositif de découpe/gravure est un laser.

Pour former des tranchées qui traversent de part en part le substrat 110, il est possible de réaliser, dans un premier temps, une étape de découpe par introduction de dislocation par laser (étape dite de 'stealth dicing') puis une étape d'expansion. L'étape dite de 'stealth dicing' consiste, avec un laser spécifique, à générer des dislocations au sein du substrat en silicium, dans les chemins de découpe. Ces dislocations sont des défauts présents dans l'épaisseur du substrat qui vont, sous l'effet d'une contrainte mécanique, vont permettre de séparer les puces. Il suffit alors d'étirer le support adhésif 200 pour écarter les puces et procéder au dépôt de matériau isolant.

Lors de l'étape c), les tranchées ou les cavités 120 sont remplies par un matériau isolant 121 depuis la face avant 111.

Le matériau isolant 121 est, de préférence, déposé par impression par jet d'encre (« inkjet ») au moyen d'une buse 300. Plusieurs passages de la buse peuvent être nécessaires pour remplir les tranchées ou les cavités 120.

Le matériau isolant est un matériau isolant électriquement. Plus particulièrement, le matériau isolant comprend un matériau de base (polymère ou résine) et, de préférence, des particules isolantes électriquement. La résine est choisie parmi le groupe comprenant : les résines de type époxy, les résines de type phénolique, les résines de type acrylique. Le matériau de base peut être de la polyvinylpyrrolidone (PVP), un silicone (aussi appelé polysiloxane), un acide polyamique, le diacrylate de tripropylène glycol (TPGDA). Les particules sont, par exemple, des particules d'oxyde, et notamment des particules d'alumine ou de silice.

De préférence, la résine est une résine thermodurcissable ou photosensible (UV). De telles résines sont très stables et résistantes à de nombreux produits chimiques.

La polymérisation de la résine est, par exemple, une étape de polymérisation UV. Elle peut également être réalisée par chauffage ou tout autre moyen de polymérisation qui sera choisi selon la nature du matériau employé.

Une étape de recuit peut être réalisée après l'étape c) .

Le procédé peut également comprendre une étape d'amincissement en face arrière (figure 3D). Cette étape est, de préférence, réalisée après l'étape c). Pour cela, la structure est retournée et fixée par sa face avant 111 sur un support 201. Le support 201 est, par exemple, une bande de ruban adhésif. La structure est, ensuite, amincie par sa face arrière 112 de façon que le substrat 110 ait son épaisseur définitive. Lorsque des cavités ont été formées à l'étape b), l'étape d'amincissement est, de préférence, réalisée de manière à amincir le substrat 110 jusqu'aux cavités 120.

Lors de l'étape d), les puces 100 sont séparées. Cette étape de singulation peut être réalisée en réalisant une découpe à travers le matériau isolant 121 (figure 3E) et le cas échéant en réalisant également une découpe à travers le substrat 110 (figures 1D, 2D). La ligne de découpe est centrée par rapport aux cavités/tranchées.

Le dispositif de découpe est, par exemple, un outil de gravure mécanique comme une scie, ou un outil de gravure par un laser. Selon un mode de réalisation préféré, le dispositif de découpe est un laser.

La tranchée réalisée lors de l'étape d) a une largeur inférieure à la tranchée ou cavité réalisée lors de l'étape b). La tranchée est centrée sur la cavité réalisée à l'étape b) .

A l'issue du procédé, les puces 100 obtenues comprennent des flancs 113 passivés. La passivation est due à la présence de la couche de matériau isolant 121. Les matériaux de brasage ne mouillent pas le matériau isolant 121.

Selon une première variante, seule une partie du flanc 113 est passivée (figure 1D). Les flancs comprennent une première partie formée dans le substrat 110, en matériau semiconducteur, et une deuxième partie en matériau isolant 121. Le matériau isolant 121 est logé dans une entaille formée dans le substrat 110. L'entaille est positionnée au niveau de l'intersection de la première face 111 et du flanc 113. L'entaille part de la première face 111 et se prolonge vers la deuxième face 112 dans un plan perpendiculaire à la première face 111 et à la deuxième face 112. Une partie du flanc 113 est formé de matériau isolant 121 et une partie de la première face 111 est formée de matériau isolant 121.

Selon une deuxième variante, la totalité du flanc 113 est passivée 2D, 3E).

Avec un tel procédé la hauteur des flancs 113 recouverte par le matériau isolant 121 peut être facilement adaptée.

Les puces 100 peuvent ensuite être fixées sur un dispositif externe, par exemple, une carte de circuit imprimé ou un autre composant, par leur face supérieure 111.

Pour cela, un matériau de brasage est positionné entre la puce 103 et le dispositif externe. Lors du brasage, même si le matériau de brasage remonte le long des flancs 113 mouillables des puces 100, elles fonctionneront correctement.

De telles puces électroniques de type CSP trouvent des applications dans de nombreux domaines industriels, et en particulier, dans le domaine de la téléphonie, dans le domaine automobile ou le domaine médical.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication de puces électroniques (100) à flancs passivés à partir d'un substrat (110) semiconducteur dont une première face (111) est recouverte par des plages de connexion (107) et dans lequel sont formées des puces (100), le procédé comprenant les étapes suivantes :
- former des tranchées ou des cavités (120) entre les puces (100),
- déposer un matériau isolant (121) dans les tranchées ou dans les cavités (120),
- séparer les puces (100) en découpant au moins le matériau isolant (121).

2. Procédé selon la revendication 1, dans lequel des tranchées (120) sont formées, les tranchées allant de la première face (111) du substrat (110) à une deuxième face (112) du substrat (110).

3. Procédé selon la revendication 1, dans lequel des cavités (120) sont formées en découpant partiellement le substrat (110) depuis la première face (111), la profondeur des cavités (120) étant de préférence comprise entre 10 et 75 % de l'épaisseur du substrat (110).

4. Procédé selon l'une quelconque des revendications précédentes, dans lequel la largeur des tranchées ou des cavités (120) est comprise entre 20 et 80 pm.

5. Procédé selon l'une quelconque des revendications 1, 3 et 4, dans lequel, avant l'étape de séparation des puces (100), le procédé comprend une étape au cours de laquelle le substrat (110) est aminci à partir d'une deuxième face (112) jusqu'à atteindre les cavités (120).

6. Procédé selon l'une quelconque des revendications précédentes, dans lequel le matériau isolant (121) comprend un polymère ou une résine, de préférence une résine époxy ou phénolique, et des charges électriquement isolantes, par exemple des particules d'alumine ou de silice.

7. Procédé selon l'une quelconque des revendications précédentes, dans lequel le matériau isolant (121) est déposée par impression par jet d'encre.

8. Procédé selon l'une des revendications précédentes, dans lequel le matériau isolant (121) est déposé uniquement dans les tranchées ou dans les cavités (120).

9. Procédé selon l'une des revendications 1 ou 3 à 8, dans lequel des cavités (120) sont formées entre les puces (100) et dans lequel l'étape de séparation des puces (100) est réalisée en découpant à travers le matériau isolant (121) et à travers le substrat (110), moyennant quoi seulement une partie des flancs (113) des puces (100) est passivée, les flancs (113) comprenant une première partie formée dans le substrat (110) et une deuxième partie formée d'une couche de matériau isolant (121) s'étendant depuis la première face (111) du substrat (110).

10. Puce électronique (100) à flancs passivés comprenant un substrat (110) semiconducteur, ayant une première face (111) recouverte par des plages de connexion (107), une deuxième face (112) et des flancs (113), au moins une partie des flancs (113) étant formée d'une couche de matériau isolant (121) s'étendant depuis la première face (111) du substrat (110).

11. Puce électronique (100) selon la revendication 10, dans lequel la couche de matériau isolant (121) va de la première face (111) à la deuxième face (112).

12. Puce électronique (100) selon la revendication 10, dans lequel une entaille partant de la première face (111) du substrat (110) est formée dans les flancs (113), l'entaille étant remplie par la couche de matériau isolant (121).
